# EUROPEAN PATENT APPLICATION

(11) **EP 2 838 116 A1**
(43) Date of publication of application: **18.02.2015**
(21) Application number: 13861513.3
(22) Date of filing: 27.09.2013
(51) Int. Cl.: H01L 25/065, H01L 23/488, H01L 23/31, H01L 21/60

(54) **STACKED PACKAGING STRUCTURE**

(30) Priority: 29.05.2013 CN 201310206479
(71) Applicant: Huawei Technologies Co., Ltd., Shenzhen, Guangdong 518129 (CN)
(72) Inventor: JIANG, Ran, Shenzhen, Guangdong 518129 (CN)
(74) Representative: Lord, Michael
(86) International application number: PCT/CN2013/084375
(87) International publication number: WO 2014/190645

(57) **Abstract**

The present invention discloses a package-on-package structure and relates to the field of electronic component packaging technologies, so as to resolve a problem that universality of a top package is limited because top and bottom packages must be collaboratively designed. The package-on-package structure includes a top package and a bottom package from top to bottom, where the bottom package includes a first substrate and a second substrate from top to bottom; a pad is placed on one surface of the first substrate, where the pad is electrically connected to the top package; a chip is placed on the other surface of the first substrate; the second substrate is placed opposite to and below the chip; a first metal terminal is placed at a position that is between the first substrate and the second substrate and bypasses the chip; the first substrate is electrically connected to one surface of the second substrate by using the first metal terminal; and a second metal terminal is placed on the other surface of the second substrate. The present invention is applicable to electronic component packaging.

## Description

### CROSS-REFERENCE TO RELATED APPLICATIONS

This application claims priority to Chinese Patent Application No. 201310206479.X, filed with the Chinese Patent Office on May 29, 2013 and entitled "PACKAGE-ON-PACKAGE STRUCTURE", which is incorporated herein by reference in its entirety.

### TECHNICAL FIELD

The present invention relates to the field of electronic component packaging technologies, and in particular, to a package-on-package structure.

### BACKGROUND

Generally, a conventional manner of packaging an electronic component in an electronic device is welding multiple independently packaged components onto one printed circuit board (Printed Circuit Board, PCB), where the electronic components are connected by using a conducting wire to implement a complete function. An arrangement of multiple independently packaged electronic components on one PCB requires a relatively large area; however, a PCB occupying a relatively large area causes both a size of an electronic device and a fabrication cost to increase. In order to enable a PCB to accommodate more electronic components and enable an electronic device to have a small PCB but have a more complex function, a package-on-package technology emerges.

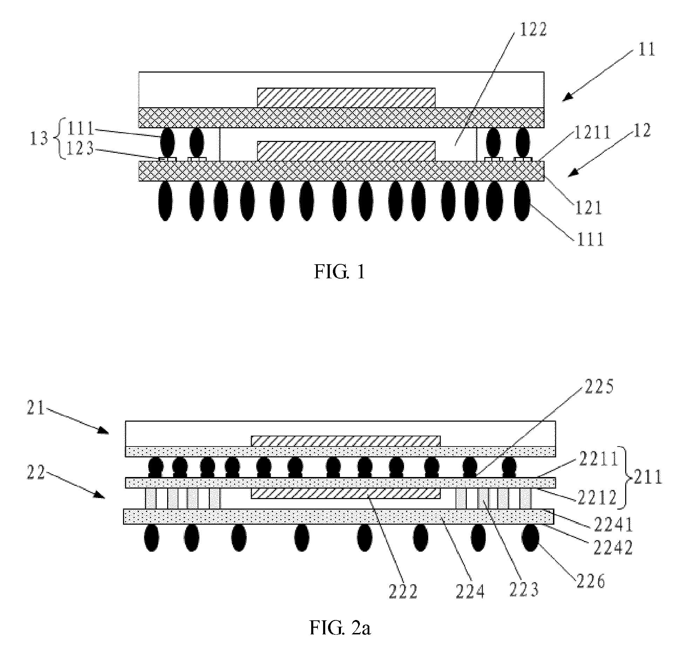

FIG. 1 is a cross-sectional diagram of a package-on-package structure in the prior art, which includes a top package 11 and a bottom package 12. A metal terminal 111 is placed on a lower surface of the top package 11; an insulation layer 122 is placed on an upper surface 1211 of a PCB 121 of the bottom package 12; and a pad 123 is placed at a position that is on the upper surface 1211 of the PCB 121 and bypasses the insulation layer 122. The metal terminal 111 is correspondingly connected to the pad 123 by using a solder ball 13 that is formed by welding.

Because the insulation layer 122 of the bottom package 12 has a specific height, a height of the solder ball 13 in a direction perpendicular to the PCB 121 must be greater than or equal to a height of the insulation layer 122, so as to ensure a welded connection between the top package 11 and the bottom package 12. However, a larger size of the solder ball 13 indicates a smaller number of solder balls 13 that can be arranged; and accordingly, a larger number of interconnection signals between the top and bottom packages (11 and 12) indicates a larger size of an electronic device. Therefore, the top and bottom packages (11 and 12) must be collaboratively designed to ensure mutual compatibility of the top and bottom packages (11 and 12) when they are electrically connected. This causes a limitation on universality of the top package 11.

### SUMMARY

Embodiments of the present invention provide a package-on-package structure, in order to resolve a problem that universality of a top package is limited because top and bottom packages must be collaboratively designed.

To achieve the foregoing objective, the embodiments of the present invention adopt the following technical solutions:

In a first aspect, the present invention provides a package-on-package structure, including a top package and a bottom package from top to bottom, where the bottom package includes a first substrate and a second substrate from top to bottom; a pad is placed on one surface of the first substrate, where the pad is electrically connected to the top package; a chip is placed on the other surface of the first substrate; the second substrate is placed opposite to and below the chip; the first metal terminal is placed at a position that is between the first substrate and the second substrate and bypasses the chip; the first substrate is electrically connected to one surface of the second substrate by using the first metal terminal; and
a second metal terminal is placed on the other surface of the second substrate.

In a first possible implementation manner, the first metal terminal is placed on the first substrate.

In a second possible implementation manner, the first metal terminal is placed on the one surface, which is connected to the first substrate, of the second substrate.

In a third possible implementation manner, the first metal terminal is placed on the first substrate and on the one surface, which is connected to the first substrate, of the second substrate.

In a fourth possible implementation manner, the metal terminals are copper cylinders, metal wires, or solder balls.

In a fifth possible implementation manner, a PCB is placed between the first metal terminal placed on the first substrate and a metal terminal placed on the second substrate, and the first metal terminals placed on the first substrate and on the second substrate are both electrically connected to the PCB.

In a sixth possible implementation manner, a manner of electrically connecting the first metal terminal and the second substrate is welding or crimping.

In a seventh possible implementation manner, both the first substrate and the second substrate are PCBs.

In an eighth possible implementation manner, the chip is connected to the first substrate by welding.

In a ninth possible implementation manner, the chip is connected to the first substrate by adhesion.

In the package-on-package structure provided by the embodiments of the present invention, the pad is placed on one surface of the first substrate and the chip is placed on the other surface, that is, the pad is placed on the one surface, which is opposite to the top package, of the first substrate, but the chip is not placed on the one surface; therefore, no other part for protecting a chip, such as an insulation layer, is placed on the one surface. Therefore, when the top package is connected to the pad on the bottom package by welding, a size, quantity, and layout of the pad on the one surface of the first substrate may be designed without a limitation of a chip and a part for protecting the chip, and the pad may be flexibly designed on the one surface, which is opposite to the chip, of the first substrate according to a requirement of the top package. This can easily ensure mutual compatibility of the top package and the bottom package when they are electrically connected, without mutual restriction, thereby avoiding a problem that the top and bottom packages must be collaboratively designed. Packaging can be completed by selecting a universal top package and directly assembling it onto the bottom package; therefore, universality of the top package is not limited.

### BRIEF DESCRIPTION OF DRAWINGS

To describe the technical solutions in the embodiments of the present invention or in the prior art more clearly, the following briefly introduces the accompanying drawings required for describing the embodiments or the prior art.
FIG. 1 is a schematic cross-sectional diagram of a package-on-package structure in the prior art;
FIG. 2a is a schematic cross-sectional diagram of a package-on-package structure provided by an embodiment of the present invention;
FIG. 2b is a schematic cross-sectional diagram of another package-on-package structure provided by an embodiment of the present invention;
FIG. 2c is a schematic cross-sectional diagram of still another package-on-package structure provided by an embodiment of the present invention;
FIG. 2d is a schematic cross-sectional diagram of yet another package-on-package structure provided by an embodiment of the present invention; and
FIG. 3 is a schematic cross-sectional diagram of still yet another package-on-package structure provided by an embodiment of the present invention.

### DESCRIPTION OF EMBODIMENTS

The following clearly and completely describes the technical solutions in the embodiments of the present invention with reference to the accompanying drawings in the embodiments of the present invention.

An embodiment of the present invention provide a package-on-package structure, which, as shown in FIG. 2a, includes a top package 21 and a bottom package 22 from top to bottom, where the bottom package 22 includes a first substrate 221 and a second substrate 224 from top to bottom; a pad 225 is placed on one surface 2211 of the first substrate 221, where the pad 225 is electrically connected to the top package 21; a chip 222 is placed on the other surface 2212 of the first substrate 221; the second substrate 224 is placed opposite to and below the chip 222; a first metal terminal 223 is placed at a position that is between the first substrate 221 and the second substrate 224 and bypasses the chip 222; the first substrate 221 is electrically connected to one surface 2241 of the second substrate 224 by using the first metal terminal 223; and a second metal terminal 226 is placed on the other surface 2242 of the second substrate 224.

The first substrate 221 and the second substrate 224 are base plates for electronic components and providers for a connection between the electronic components. The pad 225 is placed on the one surface 2211 of the first substrate 221, and the pad 225 is electrically connected to the top package 21, which can implement an electrical connection between the top package 21 and the first substrate 221. The chip 222 is placed on the other surface 2212 of the first substrate 221, the first metal terminal 223 is placed at a position that is between the first substrate 221 and the second substrate 224 and bypasses the chip 222, and the first substrate 221 is electrically connected to the one surface 2241 of the second substrate 224 by using the first metal terminal 223, so as to implement an electrical connection between the first substrate 221 and the second substrate 224. This implements the electrical connection between the top package 21 and the first substrate 221 and the electrical connection 224 between the first substrate 221 and the second substrate. Therefore, a signal can be directly transmitted between the top package 21 and the bottom package 22. A second metal terminal 226 is placed on the other surface 2242 of the second substrate 224, and the second metal terminal 226 may also enable the packaging structure to be electrically connected to an external circuit, so as to transmit the signal to the external circuit.

In the package-on-package structure provided by the embodiment of the present invention, the pad 225 is placed on one surface 2211 of the first substrate 221 and the chip 222 is placed on the other surface 2212, that is, the pad 225 is placed on the one surface 2211, which is opposite to the top package 21, of the first substrate 221 but the chip 222 is not placed on the one surface; therefore, no other part for protecting the chip 222, such as an insulation layer, is placed on the one surface 2211. Therefore, when the top package 21 is connected to the pad 225 on the bottom package 22 by welding, a size, quantity, and layout of the pad 225 on the one surface 2211 of the first substrate 221 may be designed without a limitation of the chip 222 and the part for protecting the chip 222, and the pad 225 may be flexibly designed on the one surface 2211, which is opposite to the chip 222, of the first substrate 221 according to a requirement of the top package 21. This can easily ensure mutual compatibility of the top package 21 and the bottom package 22 when they are electrically connected, without mutual restriction, thereby avoiding a problem that the top and bottom packages (21 and 22) must be collaboratively designed. Packaging can be completed by selecting a universal top package 21 and directly assembling it onto the bottom package 22; therefore, universality of the top package 21 is not limited.

In addition, in the packaging structure, the top package 21 is directly connected to the first substrate 221, and the chip 222 is placed on the first substrate 221, so that a signal of the top package 21 can be directly transmitted to the chip 222, and signals of the top package 21 and the bottom package 22 are interconnected in the first substrate 221. Therefore, a connection path between the top package 21 and the bottom package 22 is short, so that signal transmission quality is high.

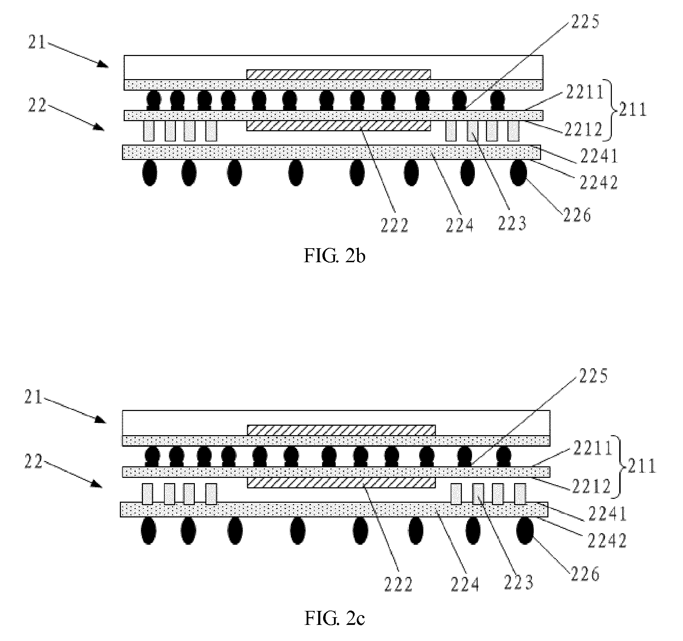

In the package-on-package structure provided by the foregoing embodiment, as shown in FIG. 2b, the first metal terminal 223 may be placed on the first substrate 221. Because a position of the chip 222 can be learnt on the first substrate 221, and the first metal terminal 223 needs to bypass the position of the chip 222, this helps accurately bypass the position of the chip 222 when the first metal terminal 223 is arranged.

In the package-on-package structure provided by the foregoing embodiment, as shown in FIG. 2c, the first metal terminal 223 may be placed on the one surface 2211, which is connected to the first substrate 221, of the second substrate 224. Because only the first metal terminal 223 is placed on the one surface 2241, which is connected to the first substrate 221, of the second substrate 224 and no other part is involved, an operation is easy to perform.

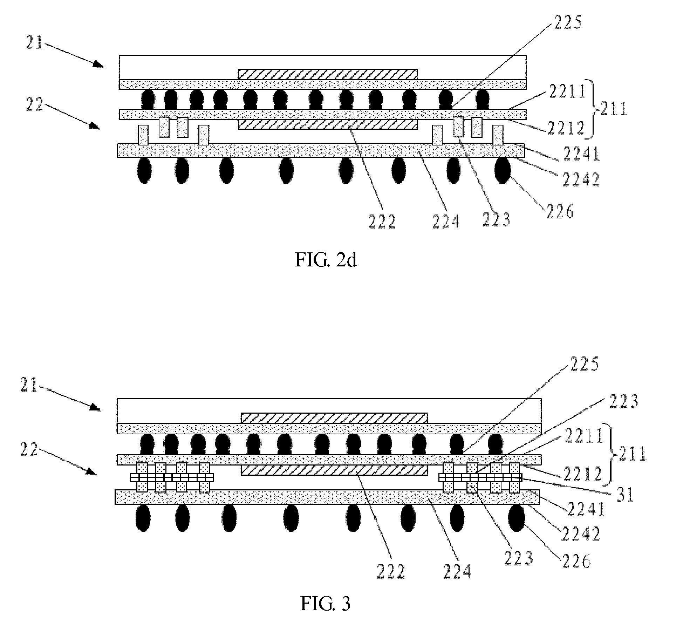

In the package-on-package structure provided by the foregoing embodiment, as shown in FIG. 2d, certainly, the first metal terminal 223 may also be placed on the second substrate 224, and on the surface 2211, which is connected to the first substrate 221, of the second substrate 224. This can also achieve an objective of electrically connecting the first substrate and the second substrate.

In the package-on-package structure provided by the foregoing embodiment, the metal terminals may be copper cylinders, metal wires, or solder balls. When a distance between the first substrate 221 and the second substrate 224 is relatively large, a copper cylinder may be selected as the first metal terminal 223, where a relatively small cross section may be designed for the copper cylinder, and a height of the copper cylinder may be flexibly designed according to the distance between the first substrate 221 and the second substrate 224. The second metal terminal 226 may also be a copper cylinder and certainly, may also be another part that can implement a function of a metal terminal.

In the package-on-package structure provided by the foregoing embodiment, as shown in FIG. 3, a PCB 31 may be placed between the first metal terminal 223 placed on the first substrate 221 and a first metal terminal 223 placed on the second substrate 224, where the first metal terminals 223 placed on the first substrate 221 and on the second substrate 224 are both electrically connected to the PCB 31. When the distance between the first substrate 221 and the second substrate 224 is relatively large, because the PCB 31 has a thickness, the PCB 31 with a specific thickness is selected to be placed between the first metal terminal 223 placed on the first substrate 221 and the first metal terminal 223 placed on the second substrate 224, which may reduce a height of the first metal terminal 223.

In the package-on-package structure provided by the foregoing embodiment, a manner of electrically connecting the first metal terminal 223 and the second substrate 224 may be welding or crimping. Because the first metal terminal 223 may be connected to the second substrate 224 by either welding or crimping, so that a current passes between the first metal terminal 223 and the second substrate 224, and an electrical connection is implemented.

In the package-on-package structure provided by the foregoing embodiment, both the first substrate 221 and the second substrate 224 may be PCBs. A PCB is a provider for an electrical connection between electronic components. Development of PCBs has a history of over 100 years. A main advantage of using a PCB is to significantly reduce an error in wire layout and assembly, which improves an automation level and labor productivity.

In the package-on-package structure provided by the foregoing embodiment, the chip 222 may be connected to the first substrate 221 by welding. A welded connection is stable and firm, and may enable the chip 222 to be better fixed on the first substrate 221.

In the package-on-package structure provided by the foregoing embodiment, the chip 222 may be connected to the first substrate 221 by adhesion. An adhesion connection is simple and easy to operate which may be implemented easily.

The foregoing descriptions are merely specific embodiments of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. Apackage-on-package structure, comprising a top package and a bottom package from top to bottom; wherein the bottom package comprises a first substrate and a second substrate from top to bottom; a pad is placed on one surface of the first substrate, wherein the pad is electrically connected to the top package; a chip is placed on the other surface of the first substrate; the second substrate is placed opposite to and below the chip; the first metal terminal is placed at a position that is between the first substrate and the second substrate and bypasses the chip; the first substrate is electrically connected to one surface of the second substrate by using the first metal terminal; and a second metal terminal is placed on the other surface of the second substrate.

2. The package-on-package structure according to claim 1, wherein the first metal terminal is placed on the first substrate.

3. The package-on-package structure according to claim 1, wherein the first metal terminal is placed on the one surface, which is connected to the first substrate, of the second substrate.

4. The package-on-package structure according to claim 1, wherein the first metal terminal is placed on the first substrate, and on the surface, which is connected to the first substrate, of the second substrate.

5. The package-on-package structure according to any one of claims 1 to 4, wherein the metal terminals are copper cylinders, metal wires, or solder balls.

6. The package-on-package structure according to claim 4, wherein a PCB is placed between the first metal terminal placed on the first substrate and a first metal terminal placed on the second substrate, and the first metal terminals placed on the first substrate and on the second substrate are both electrically connected to the PCB.

7. The package-on-package structure according to any one of claims 1 to 4, wherein a manner of electrically connecting the first metal terminal and the second substrate is welding or crimping.

8. The package-on-package structure according to any one of claims 1 to 4, wherein both the first substrate and the second substrate are PCBs.

9. The package-on-package structure according to any one of claims 1 to 4, wherein the chip is connected to the first substrate by welding.

10. The package-on-package structure according to any one of claims 1 to 4, wherein the chip is connected to the first substrate by adhesion.
